# EUROPÄISCHE PATENTANMELDUNG

(11) **EP 1 492 201 A2**
(43) Veröffentlichungstag der Anmeldung: **29.12.2004**
(21) Anmeldenummer: 04009171.2
(22) Anmeldetag: 16.04.2004
(51) Int. Cl.: H01R 12/32

(54) **Verbindungsstift für die Verbindung zweier Platinen**

(30) Priorität: 23.06.2003 DE 10328282
(71) Anmelder: Rexroth Indramat GmbH, 97816 Lohr am Main (DE)
(72) Erfinder: Amend, Matthias, 97840 Hafenlohr (DE)
(74) Vertreter: Thürer, Andreas

(57) **Zusammenfassung**

Verbindungsstift 1, der eine Grundplatine 2 mit einer Zusatzplatine 3 unter Einhaltung eines Mindest-Querabstandes der Platinen verbindet, wobei ein Verlötende des Verbindungsstiftes mit einem Einsetz-Längsabschnitt in eine korrespondierende Ausnehmungsgeometrie 25 an der Grundplatine eingreift und im Eingriff dort zu verlöten ist, um bei gleichem bis verringertem Fertigungsaufwand und verringerter Ausschussrate eine zuverlässigere und belastbarere Verbindung zu schaffen, wobei der Einsetz-Längsabschnitt mit dem Verbindungsstift 1 einstückig ausgebildet ist und in seiner Eingriffsstellung mit der Ausnehmungsgeometrie 25 einen Drehformschluss bezüglich einer Verbindungsstift-Längsachse ausbildet, wobei Formschluss-Geometrieelemente der Ausnehmungsgeometrie 25 in der Grundplatine 2 vorgesehen sind.

## Beschreibung

Die Erfindung betrifft einen Verbindungsstift nach dem Oberbegriff des Anspruchs 1), sowie ein Verfahren zur Herstellung eines solchen Verbindungsstifts und eine entsprechend ausgestaltete Grundplatine nach dem Anspruch 11).

Ein solcher Verbindungsstift dient zur Verbindung einer Grundplatine mit einer Zusatzplatine, wobei Grundplatine in diesem Zusammenhang lediglich diejenige Platine bedeutet, wo ein Verlötende verlötet ist. Die Grundplatine muss nicht hinsichtlich ihrer elektrischen Eigenschaften eine Grundplatine bilden, also wesentliche elektrische Funktionen ausüben oder die Stromversorgung für eine Zusatzplatine bieten. Die Begriffe Grundplatine und Zusatzplatine sind lediglich unter Unterscheidungsgesichtspunkten gewählt und prinzipiell auch durch erste Platine und zweite Platine ohne jegliche elektrische oder mechanische Bedeutung austauschbar.

Ein erfindungsgemäßer Verbindungsstift dient zur Verbindung einer Grundplatine mit einer Zusatzplatine, und zwar unter Einhaltung eines Mindest-Querabstandes der Platinen zueinander; dieser Mindest-Querabstand wird meist senkrecht zu den zueinander parallel verlaufenden Großflächen der jeweiligen Platinen gemessen. Der Abstand ist stets so groß bemessen, dass die vorgesehenen Bauteile in dem Zwischenraum zwischen den beiden Platinen ausreichend Platz finden und andererseits auch eine ausreichende Durchströmung mit z.B. Kühlluft gegeben ist. Solche Verbindungsstifte sind bekannt; sie werden mit einem Einsetz-Längsabschnitt - beispielsweise einem Außengewinde - in eine korrespondierende Ausnehmungsgeometrie an der Grundplatine eingesetzt bzw. eingeschraubt. Dort werden sie im Eingriff verlötet. Falls der Einsetz-Längsabschnitt durch ein Gewinde gebildet wird, ist in die Grundplatine meist eine Einpressmutter eingepresst, die ein entsprechendes Innengewinde zum Einschrauben des korrespondierenden Außengewindes des Einsetz-Längsabschnitts bietet.

Ein solcher Verbindungsstift hat auf der gegenüberliegenden Längsseite meist ein Innengewinde, dieses Innengewinde liegt an der Zusatzplatine an. Die Zusatzplatine hat ein mit dem Innengewinde im wesentlichen fluchtendes Durchgangsloch zum Befestigen der Zusatzplatine mit einer Schraube an dem Innengewinde des Verbindungsstifts.

Es hat sich in der Praxis gezeigt, dass ein hoher Ausschuss beim Einpressen der Einpressmutter in die Grundplatine entsteht. Dann ist die gesamte Grundplatine mit ggf. bereits darauf angebrachten elektrischen Bauteilen verloren. Zudem ist die Verbindung mittels des oben angegebenen Verfahrens ein aufwendiger Prozess, da die Einpressmutter eingepresst, der Verbindungsstift mit seinem Einsetz-Längsabschnitt in die Einpressmutter eingeschraubt und dann verlötet werden muss. Es zeigt sich auch regelmäßig, dass aufgrund der sehr geringen Verfüllung des Einsetz-Längsabschnitts in der eingeschraubten Position mit Lot die Ausreißfestigkeit gering ist. Diese ist im wesentlichen gegeben durch die Ausreißfestigkeit der lediglich eingepressten Einpressmutter.

Es ist daher Aufgabe der vorliegenden Erfindung, bei gleichem bis verringertem Fertigungsaufwand und verringerter Ausschussrate eine zuverlässigere und belastbarere Verbindung zu schaffen.

Diese Aufgabe wird gelöst durch die Merkmale des Anspruchs 1).

Die Erfindung bietet den Vorteil eines einfacheren Verfahrens zur Verbindung von Grundplatine und Zusatzplatine durch eine Fertigung mit weniger Fertigungsschritten, wobei die einzelnen Fertigungsschritte wesentlich weniger aufwendig und auch einfacher automatisiert durchzuführen sind. Außerdem ist mit einem erfindungsgemäßen Verbindungsstift die Verbindung praktisch ohne Beschädigung bzw. ohne Ausschuss der Grundplatine zu bewerkstelligen, da der Verbindungsstift leicht einzusetzen ist. Zudem weist die Verbindung - insbesondere hinsichtlich der Befestigung an der Grundplatine - eine höhere Ausreiß- und Drehfestigkeit auf.

Diese Vorteile werden dadurch erreicht, dass der Einsetz-Längsabschnitt mit dem Verbindungsstift einstückig ausgebildet ist. Dadurch kann zunächst auf ein zusätzliches Einsetzteil - wie beispielsweise eine Einpressmutter - verzichtet werden, so dass eine Schwachstelle - nämlich die Verbindung zwischen Einspressmutter und Verbindungsstift - ausgeschaltet ist. Der Einsetz-Längsabschnitt bildet in seiner Eingriffsstellung mit der Ausnehmungsgeometrie einen Drehformschluss bezüglich einer Verbindungsstift-Längsachse aus, wobei Formschluss-Geometrieelemente der Ausnehmungsgeometrie in der Grundplatine vorgesehen sind. In der Ausnehmungsgeometrie sind vorzugsweise Drehformschluss-Geometrieelemente vorgesehen. Daher muss der Einsetz-Längsabschnitt lediglich in die Ausnehmungsgeometrie eingesetzt und in der Regel nicht mit weiteren Maßnahmen - wie beispielsweise Einschrauben - vor dem Verlöten bearbeitet werden. Es entfallen somit die Fertigungsschritte des Einschraubens und des vorherigen Einpressens gegenüber dem Stand der Technik.

Der Verbindungsstift sitzt nach dem Verlöten bezüglich Verdrehung und bezüglich axialer und radialer Krafteinwirkung und gegenüber Verkippungsmomenten sehr fest an der Grundplatine.

Insbesondere bei den hier beanspruchten Verbindungsstiften - die vergleichsweise dünn ausgebildet sind - entfaltet die Erfindung ihre besonderen Vorteile. Gerade bei vergleichsweise kleiner Grundrissfläche ist eine effiziente Ausnutzung des Befestigungsquerschnitts geboten, um eine ausreichende Befestigung bei einfacher Fertigung erzielen zu können.

Solche Verbindungsstifte werden in großen Stückzahlen hergestellt und bei der Leiterkartenfertigung eingesetzt, so dass sich der erfindungsgemäße Vorteil auch bei der Serien- bzw. Massenfertigung entsprechend multipliziert auswirkt. Die erzielten Einsparungen bei der Fertigung und die erzielte Verringerung der Ausschussrate wirken sich mit dem entsprechenden Multiplikationshebel aus.

Nach der Verlötung des Einsetz-Längsabschnitts in seinem Sitz in der Grundplatine wird die formschlüssige Drehhemmung ergänzt durch einen auszugssicheren Schutz gegen axiale oder auch radiale Kräfte. Dies ist dadurch gewährleistet, dass das Lot, welches in der Regel an der dem Verbindungsstift gegenüberliegenden Großfläche der Grundplatine aufgebracht wird, die verbleibenden Fugen und Spalten zwischen Einsetz-Längsabschnitt und Ausnehmungsgeometrie der Grundplatine verfüllt und nach bekannter Weise einen Lötanteil an dieser Seite bildet, der die axiale Auszugssicherheit gibt.

Die Geometrie des Einsetz-Längsabschnitts korrespondiert dabei mit derjenigen der Ausnehmungsgeometrie im Sinne der Bildung eines Drehformschlusses. Der Einsetz-Längsabschnitt ist in die Ausnehmungsgeometrie einsetzbar. Es können eine Vielzahl von Geometrien von Einsetz-Längsabschnitten vorgesehen sein, beispielsweise einzelne Eingriffszapfen oder -stifte, unrunde Geometrien (im Grundriss gesehen) etc. Man korrespondiert die Ausnehmungsgeometrie mit der unrunden Grundriss-Geometrie des Einsetz-Längsabschnitts bzw. mit den Einsetzstiften oder -zapfen, beispielsweise durch mehrere, korrespondierende Bohrungen. Hierauf wird später noch näher eingegangen.

Die Formschluss-Geometrieelemente der Ausnehmungsgeometrie können bereits in der Grundplatine vorgesehen sein oder nachträglich z.B. durch Bohrungen eingebracht werden.

Bevorzugte Ausgestaltungen der vorliegenden Erfindung sind in den Unteransprüchen beschrieben.

Damit auch auf der Seite der Großfläche, die dem Verbindungsstift zugewandt ist, ein Widerlager für einen sichereren Halt und eine höhere Steifigkeit und Verkippungsfestigkeit erreicht wird, soll zumindest in einem Umfangsabschnitt des Verbindungsstifts der Einsetz-Längsabschnitt gegenüber einem lokalen Außenmaß des Verbindungsstifts zurückspringen, so dass der Verbindungsstift eine umfangsäußere Abstützkante aufweist. Die umfangsäußere Abstützkante stützt sich an der oben genannten Seite der Grundplatine ab. Insbesondere kann der Einsetz-Längsabschnitt über praktisch den gesamten Umfang des Verbindungsstifts zurückspringen, so dass sich ein Abstütz-Ringbund des Verbindungsstifts über im wesentlichen den gesamten Außenumfang des Verbindungsstifts erstreckt, mit dem sich der Verbindungsstift im äußeren Bereich der Ausnehmungsgeometrie abstützt. Dann ist hinsichtlich jeglicher Verkippungsrichtung eine Verkippung praktisch ausgeschlossen. In beiden Fällen stützt sich der Verbindungsstift vorzugsweise außerhalb der eigentlichen Ausnehmungsgeometrie ab, beispielsweise nach Art eines Ringbundes wie ein Flunch.

Bevorzugt soll der effektive Außendurchmesser des Verbindungsstifts zwischen 4 und 9 mm betragen, insbesondere beträgt der effektive Außendurchmesser des Verbindungsstifts zwischen 5 bis 7 mm. Die effiziente Raumausnützung für die sichere Befestigung - wie oben beschrieben - wirkt sich insbesondere bei dünneren Verbindungsstiften im Sinne einer zuverlässigen Befestigung bei sehr geringen, miteinander fluchtenden Befestigungsgrundflächen aus.

Dies ist insbesondere der Fall, wenn das Verhältnis von effektivem Außendurchmesser zur Gesamtlänge, inklusive Einsetz-Längsabschnitt, des Verbindungsstifts zwischen 1 : 2,5 bis 1 : 4,0, insbesondere 1 : 3,0 bis 1 : 3,5, beträgt.

Eine hohe Verdrehsicherheit wird dadurch gewährleistet, dass der Einsetz-Längsabschnitt zwei, drei oder vier, insbesondere vier, weiter insbesondere in Umfangsrichtung mit entsprechender zwei- drei- oder vierzähliger Drehsymmetrie angeordnete, Längsstifte aufweist, die in korrespondierende Bohrungen der Grundplatine einzusetzen sind. Dabei ist insbesondere von Vorteil, dass die Anforderung an die Übereinstimmung der Grundrisse von Längsstiften und Bohrungen sehr gering sind. Die Längsstifte müssen lediglich in die Bohrungen einsetzbar sein und ansonsten kann durchaus zwischen der Außenkontur der Längsstifte und der Innenwandung der Bohrungen noch Freiraum bzw. ein Spiel vorhanden sein. Dieser Freiraum bzw. dieses Spiel sollte allerdings derart bemessen sein, dass trotzdem noch eine ausreichend genaue Positionierung in Flächenrichtung der Grundplatine erfolgen kann, so dass mehrere, in dieselbe Grundplatine eingesetzte Verbindungsstifte mit korrespondierenden Bohrungen oder Befestigungslöchern der Zusatzplatine gleichzeitig fluchten können.

Durch die Einstückigkeit des Verbindungsstifts zusammen mit der Verlötung in der Grundplatine können kleinere oder auch größere Ströme ohne weiteres über den Verbindungsstift übertragen werden, ohne dass die Gefahr einer Leitungsunterbrechung auftritt. Daher wird vorgeschlagen, dass ein mit der Grundplatine verlöteter und mit der Zusatzplatine verbundener Verbindungsstift zwischen Grundplatine und Zusatzplatine zur Leitung elektrischer Signale, elektrischer Leistung oder zum Erd-/Masseanschluss ausgelegt ist und entsprechende Leiterbahnen und Anschlüsse auf der jeweiligen Platine vorgesehen sind.

Die oben genannte Aufgabe wird ferner durch ein Verfahren zur Herstellung eines Verbindungsstifts nach Anspruch 1), 2) und 8) gelöst. Ein solches Verfahren ist gegenüber herkömmlichen Verbindungsstiften sehr einfach und mit weniger Schritten durchzuführen. Generell sind die nötigen Bearbeitungsschritte Standard-Umformverfahren, wie Drehen und Fräsen, so dass der Stift nicht mit einer teuren Gussform fertig gegossen, sondern als einfaches Halbzeug schnell und effizient gefertigt werden kann.

Die Erfindung betrifft auch eine Grundplatine nach dem Oberbegriff des Anspruchs 11). Eine solche Grundplatine löst die oben genannte Aufgabe. Eine solche Grundplatine kann völlig unabhängig von der Fertigung der Verbindungsstifte und etwaiger Zusätze hergestellt werden. Vorzugsweise sind nämlich außer Verbindungsstift, Grundplatine mit Ausnehmungsgeometrie und Lot keinerlei weitere Zusatzelemente, wie beispielsweise Einpressmuttern, erforderlich.

Die Erfindung wird anhand eines Ausführungsbeispiels in den Figuren im folgenden näher erläutert. Es zeigen:
- Figur 1: eine perspektivische Explosionszeichnung einer Grundplatine, einer Zusatzplatine und Verbindungsstiften sowie Befestigungsschrauben gemäß der Erfindung,
- Figur 2: eine perspektivische Draufsicht auf einen Verbindungsstift gemäß der vorliegenden Erfindung,
- Figur 3a: eine Draufsicht in Axialrichtung gesehen auf den Einsetz-Längsabschnitt des Verbindungsstifts aus Figur 2,
- Figur 3b: eine Draufsicht auf die gegenüberliegende Seite, ebenfalls in Axialrichtung gesehen, des Verbindungsstifts der Figur 2,
- Figur 4: eine Draufsicht auf einen Ausschnitt der Grundplatine mit entsprechender Ausnehmungsgeometrie.

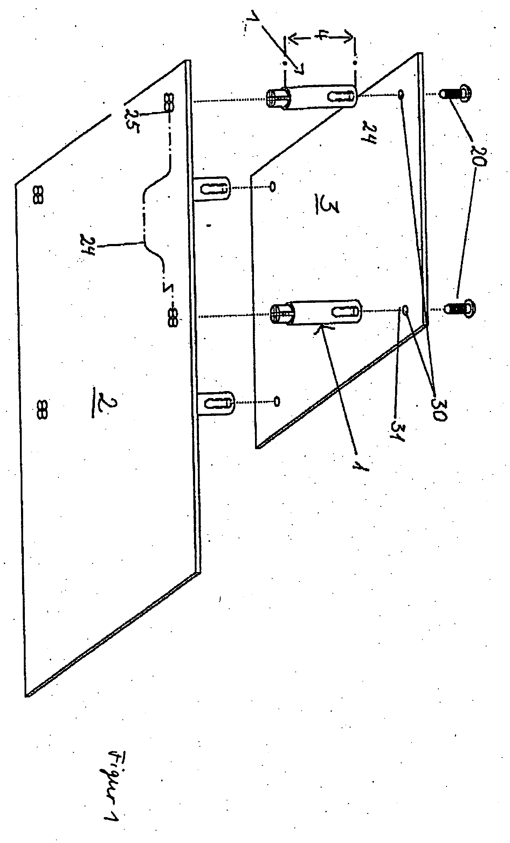

Figur 1 zeigt eine perspektivische Ansicht von unten in Explosionsdarstellung einer Grundplatine 2, die mit einer Zusatzplatine 3 mit einem erfindungsgemäßen Verbindungsstift 1 zu verbinden ist. Dabei sind elektrische Bauteile und die meisten Leiterbahnen etc. von Grundplatine 2 und Zusatzplatine 3 der Übersichtlichkeit halber weggelassen.

Wie in Figur 1 dargestellt, ist die Anordnung gemäß der punktierten Linien zusammen zu setzen. Im zusammengesetzten Zustand sind Grundplatine 2 und Zusatzplatine 3 durch entsprechende Anschläge (hierauf wird später noch näher eingegangen) unter Einhaltung des dadurch vorgegebenen Mindest-Querabstandes 4 angeordnet. In der Figur 1 sind vier Verbindungsstifte 1 vorgesehen, um eine gleichmäßige Abstützung und eine symmetrische Befestigung zu gewährleisten. Die Verbindungsstifte sind in ihrem Sitz jeweils an den vier äußeren Ecken der rechteckigen Zusatzplatine 3 angeordnet.

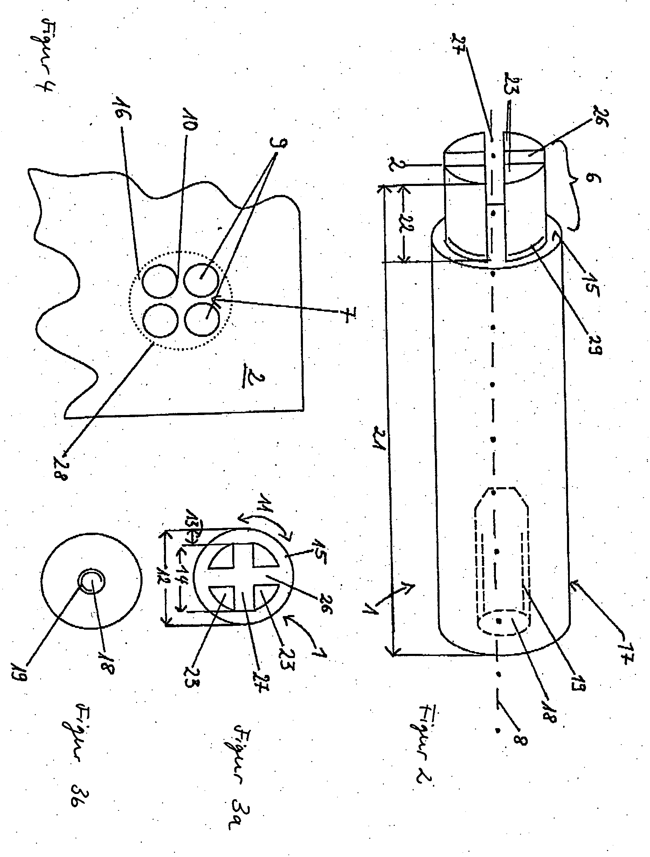

Die weitere Beschreibung erfolgt unter gleichzeitiger Bezugnahme auf die Figuren 1 und 2. Jeder der Verbindungsstifte 1 hat jeweils einen Einsetz-Längsabschnitt 6 an seinem Verlötende 5. Der Einsetz-Längsabschnitt 6 ist mit dem Verbindungsstift 1 einstückig ausgebildet; er kann beispielsweise aus einem durchgehenden, zylindrischen Bolzen hergestellt sein.

Der Verbindungsstift 1 greift mit dem Einsetz-Längsabschnitt 6 in eine korrespondierende Ausnehmungsgeometrie 7 ein, so dass in seiner Eingriffsstellung mit der Ausnehmungsgeometrie 7 ein Drehformschluss bezüglich einer Verbindungsstift-Längsachse 8 ausgebildet wird. Die korrespondierenden Formschluss-Geometrieelemente der Ausnehmungsgeometrie sind im Material der Grundplatine 2 vorgesehen.

Im einzelnen weist der Einsetz-Längsabschnitt 6 eine Länge 22 auf, die die Eingriffslänge des Einsetz-Längsabschnitts 6 definiert. Dafür sind vier Längsstifte 23 im Einsetz-Längsabschnitt 6 vorgesehen, die eine 90 Grad-Drehsymmetrie zueinander - und zwar bezüglich der Längsachse 8 - aufweisen. Über den gesamten Umfang des Verbindungsstiftes 1 wird der Einsetz-Längsabschnitt 6 durch einen Abstütz-Ringbund 15 in Axialrichtung gesehen begrenzt. Der Verbindungsstift 1 stützt sich mit dem Ringbund 15 in seiner Montagelage auf der Hauptplatine 2 ab. Dadurch wird eine umfangsäußere Abstützkante gebildet; hierfür springt der Einsetz-Längsabschnitt gegenüber einem lokalen Außenmaß 12 (siehe Figur 4a) zurück (siehe weiter unten).

Am gegenüberliegenden Ende 17 des Verbindungsstiftes 1 ist ein Gewindeloch 18 mit Innengewinde 19 vorgesehen, in welches eine Befestigungsschraube 20 zur Befestigung der Zusatzplatine 3 in der Montagelage durch das jeweils dafür vorgesehene Durchsteckloch 30 einzuschrauben ist.

In der in Figur 1 durch gepunktete Linien angedeuteten Montagelage wird der Einsetz-Längsabschnitt 6 in seinem Sitz von unten mit der Grundplatine 2 verlötet. Dadurch wird es möglich, dass - auch aufgrund der Einstückigkeit des Verbindungsstiftes 6 - eine unterbrechungsfreie und solide Leitung von Signalen oder Versorgungsströmen über den Verbindungsstift 1 oder über mehrere Verbindungsstifte 1 erfolgen kann. Hierzu sind in Figur 1 an der Unterseite der Hauptplatine 2 ein Anschluss 25 sowie eine Leiterbahn 24 jeweils schematisch angedeutet, die von einem Verbindungsstift 6 zu einem anderen Verbindungsstift 6 verläuft. Prinzipiell können Leiterbahnen auch zu elektrischen Teilen der Grundplatine 2 und/oder der Hauptplatine 3 vorgesehen sein.

Folgende Beschreibung der Geometrien erfolgt unter gleichzeitiger Bezugnahme auf die Figuren 2, 3, 4a und 4b.

Die Gesamtlänge 22 des Verbindungsstiftes 1 setzt sich im wesentlichen zusammen aus dem Stiftkörper 32 und dem Einsetz-Längsabschnitt 6. Die Längsstifte 23 des Einsetz-Längsabschnittes 6 haben in Axialrichtung gesehen nahe dem Ririgbund 15 einen Freistich 29 für einen besseren Sitz des Einsetz-Längsabschnitts 6; dadurch kann - wenn entsprechende Toleranzen vorgesehen sind zwischen Ausnehmungsgeometrie 7 und Einsetz-Längsabschnitt 6 - auch eine Art Einrasten des Einsetz-Längsabschnitts 6 in der vorgesehenen Montageposition erreicht werden.

Die Ausnehmungsgeometrie 7 hat vier in korrespondierender Anordnung gelegene Einsetzbohrungen 9. Der Einsetz-Längsabschnitt 6 wird mit seinen Längsstiften 23 durch die korrespondierenden Einsetzbohrungen 9 hindurch gesteckt und liegt dann mit der umfangsäußeren Abstützkante 15 - wie dies in Figur 3 durch den gestrichelten Kreis angedeutet ist - auf der Grundplatine 2 auf. Dadurch wird eine bessere Abstützung und Halterung gegen Verkippungskräfte des Verbindungsstiftes 1 gewährleistet. Dafür springt der effektive Außendurchmesser (der Außendurchmesser der Einhüllenden des Einsetz-Längsabschnitts) hinter den Außendurchmesser 12 des zylindrischen Abschnitts des Verbindungsstifts 1 zurück, so dass ein Bundmaß 13 gebildet ist, mit dem der Verbindungsstift auch außerhalb der Einsetzbohrungen 9 der Grundplatine 2, also im äußeren Bereich 16, aufliegt.

Bei dem gezeigten Einsetz-Längsabschnitt 6 ist zunächst eine Durchmesserstufe in einen zylindrischen Bolzen - ggf. mit Innengewinde für die Verschraubung am Ende 17 - eingedreht worden, deren Höhe den Einsetz-Längsbereich 6 definiert. Dann sind zwei sich unter einem Winkel von 90 Grad kreuzende Radialnuten 26, 27 bis auf den Grund des Einsetz-Längsabschnitts 6 eingefräst worden. Dadurch bleiben als Längsstifte 4 symmetrisch angeordnete, längliche Zylindersegmente stehen. Diese Längsstifte 23 werden durch die Einsetzbohrung 9 hindurch gesteckt. Dafür sind sie in der Flucht mit den Einsetzbohrungen 9 gesehen derart bemessen, dass sie mit geringem Spiel oder mit leichter Presspassung in die Einsetzbohrungen 9 hinein passen.

Im Ergebnis liegt der Verbindungsstift 1 - wie durch den auf die Grundplatine 2 abgetragenen Außendurchmesser 28 angegeben - dort auf, und zwar im äußeren Bereich der Ausnehmungsgeometrie, und insbesondere außerhalb der zwischen den einzelnen Einsetzbohrungen 9 verbleibenden Zwischenstege 10, so dass sich die in Figur 3 gezeigte Überdeckung ergibt.

Die Verlötung des Einsetz-Längsbereichs 6 in seinem Sitz in der Ausnehmungsgeometrie 7 ist hier nicht im einzelnen gezeigt. In Figur 3 würden die Längsstifte 23 durch die gezeigten Einsetzbohrungen 9 hindurch ragen, so dass aufgrund der ungleichen Grundrissgeometrie von Längsstiften und Einsetzbohrungen 9 zwischen der Innenwandung der Einsetzbohrungen 9 und der jeweiligen Außenwandung der Längsstifte 23 jeweils Freiräume verbleiben, die beim Verlöten mit Lot verfüllt werden und dadurch eine sehr hohe Auszugsfestigkeit und Festigkeit gegenüber Verkippungskräften gewährleistet. Außerdem wird dadurch die Kontaktfläche zwischen Lot und Ausnehmungsgeometrie 7 und Einsetz-Längsbereich 6 sehr groß. Innerhalb des gezeigten Außendurchmessers 28 könnte noch eine lotempfängliche Metallbeschichtung auf der Grundplatine vorgesehen sein. Dann entspricht die räumliche Ausdehnung des Lötbereichs im wesentlichen der gepunkteten Linie 28, wobei vorzugsweise die Enden der Längsstifte 23 gänzlich mit Lot bedeckt sind, so dass eine durchgehende Lotbedeckung des gesamten Innenbereichs des Außendurchmessers 28 resultiert.

### Bezugszeichenliste

- 1: Verbindungsstift
- 2: Grundplatine
- 3: Zusatzplatine
- 4: Mindest-Querabstand
- 5: Verlötende
- 6: Einsetz-Längsabschnitt
- 7: Ausnehmungsgeometrie
- 8: Verbindungsstift-Längsachse
- 9: Einsetzbohrung der Grundplatine
- 10: verbleibender Zwischensteg
- 11: Umfangsrichtung
- 12: Außendurchmesser
- 13: Bundmaß
- 14: effektiver Außendurchmesser des Einsetz-Längsabschnitts
- 15: umfangsäußere Abstützkante / Ringbund
- 16: äußerer Bereich der Ausnehmungsgeometrie
- 17: dem Verlötende gegenüberliegendes Längsende
- 18: Gewindeloch
- 19: Innengewinde
- 20: Befestigungsschraube
- 21: Gesamtlänge des Verbindungsstiftes
- 22: Länge des Einsetz-Längsabschnitts
- 23: Längsstift
- 24: Leiterbahn
- 25: Anschluss
- 26: Radialnut
- 27: Radialnut
- 28: Außendurchmesser des Verbindungsstifts abgetragen auf die Grundplatine
- 29: Freistich
- 30: Durchsteckloch
- 31: Anschluss
- 32: Stiftkörper

## Patentansprüche

1. Verbindungsstift (1), der eine Grundplatine (2) mit einer Zusatzplatine (3) unter Einhaltung eines Mindest-Querabstandes (4) der Platinen (2, 3) verbindet, wobei ein Verlötende (5) des Verbindungsstiftes (1) mit einem Einsetz-Längsabschnitt (6) in eine korrespondierende Ausnehmungsgeometrie (7) an der Grundplatine (2) eingreift und im Eingriff dort zu verlöten ist, **dadurch gekennzeichnet, dass**
der Einsetz-Längsabschnitt (6) mit dem Verbindungsstift (1) einstückig ausgebildet ist und in seiner Eingriffsstellung mit der Ausnehmungsgeometrie (7) einen Drehformschluss bezüglich einer Verbindungsstift-Längsachse (8) ausbildet, wobei Formschluss-Geometrieelemente (10) der Ausnehmungsgeometrie (7) in der Grundplatine (2) vorgesehen sind.

2. Verbindungsstift nach Anspruch 1), **dadurch gekennzeichnet, dass**
zumindest in einem Umfangsabschnitt des Verbindungsstifts (1) der Einsetz-Längsabschnitt gegenüber einem lokalen Außenmaß (12) des Verbindungsstifts (1) zurückspringt, so dass der Verbindungsstift (1) eine umfangsäußere Abstützkante (15) aufweist.

3. Verbindungsstift nach Anspruch 2), **dadurch gekennzeichnet, dass**
sich ein Abstütz-Ringbund (15) des Verbindungsstifts (1) über im wesentlichen den gesamten Außenumfang (11) des Verbindungsstifts (1) erstreckt, mit dem sich der Verbindungsstift (1) im äußeren Bereich (16) der Ausnehmungsgeometrie (7) abstützt.

4. Verbindungsstift nach einem der Ansprüche 1) bis 3), **dadurch gekennzeichnet, dass**
der Verbindungsstift (1) an seinem dem Verlötende (5) gegenüberliegenden Längsende (17) ein Befestigungsmittel (18, 19) für eine Befestigung der Zusatzplatine (3), insbesondere ein Innengewinde (19) zum Einschrauben einer Befestigungsschraube (20), aufweist.

5. Verbindungsstift nach einem der Ansprüche 1) bis 4), **dadurch gekennzeichnet, dass**
der effektive Außendurchmesser (12) des Verbindungsstifts (1) zwischen 4 und 9 mm beträgt.

6. Verbindungsstift nach Anspruch 5), **dadurch gekennzeichnet, dass**
der effektive Außendurchmesser (12) des Verbindungsstifts (1) zwischen 5 und 7 mm beträgt.

7. Verbindungsstift nach einem der Ansprüche 1) bis 6), **dadurch gekennzeichnet, dass**
das Verhältnis von effektivem Außendurchmesser (12) zu Gesamtlänge (21), inklusive Einsetz-Längsabschnitt (6), des Verbindungsstifts (1) zwischen 1 : 2,5 bis 1 : 4,0, insbesondere 1 : 3,0 bis 1 : 3,5, beträgt.

8. Verbindungsstift nach einem der Ansprüche 1) bis 7), **dadurch gekennzeichnet, dass**
der Einsetz-Längsabschnitt (6) zwei, drei oder vier, insbesondere vier, weitere insbesondere in Umfangsrichtung (11) mit entsprechender zwei- drei- oder vierzähliger Drehsymmetrie angeordnete, Längsstifte (23) aufweist, die in korrespondierende Bohrungen (9) der Grundplatine (2) einzusetzen sind.

9. Verbindungsstift nach einem der Ansprüche 1) bis 8), **dadurch gekennzeichnet, dass**
ein mit der Grundplatine (2) verlöteter und mit der Zusatzplatine (3) verbundener Verbindungsstift (1) zwischen Grundplatine (2) und Zusatzplatine (3) zur Leitung elektrischer Signale, elektrischer Leistung oder zum Erd-/Masseanschluss ausgelegt ist und entsprechende Leiterbahnen (24) und Anschlüsse (25) auf der jeweiligen Platine (2, 3) vorgesehen sind.

10. Verfahren zur Herstellung eines Verbindungsstifts nach Anspruch 1), 2) und 8), **dadurch gekennzeichnet, dass**
in einen Metallstift im vorgesehenen Einsetz-Längsbereich (6) eine entsprechende Durchmesser-Endstufe eingedreht und anschließend der verbleibende, durchmesserverringerte, entstehende Einsetz-Längsbereich (6) durch Einfräsen einer oder zweier, sich vorzugsweise senkrecht kreuzender, Radialnuten (26, 27) in verbleibende Längsstifte (23) geteilt wird.

11. Grundplatine (2) mit zumindest einer Ausnehmungsgeometrie (7), die mit einem Einsetz-Längsabschnitt (6) eines Verbindungsstifts (1) nach den Ansprüchen 1), 2) und 8) korrespondiert, **dadurch gekennzeichnet, dass**
eine entsprechende Anzahl von Bohrungen in geometrisch entsprechender Anordnung in die Grundplatine (2) eingebracht ist.
